(19) **Europäisches Patentamt**
**European Patent Office**
**Office européen des brevets**

(11) **EP 1 791 263 B1**

(12) **EUROPÄISCHE PATENTSCHRIFT**

(45) Veröffentlichungstag und Bekanntmachung des Hinweises auf die Patenterteilung:
**28.05.2008 Patentblatt 2008/22**

(51) Int Cl.:
***H03L 7/10*** *(2006.01)*      *H03L 7/087* *(2006.01)*
***H03L 7/095*** *(2006.01)*

(21) Anmeldenummer: **06023973.8**

(22) Anmeldetag: **18.11.2006**

(54) **Phasenregelkreis mit Reduzierter Einschwingzeit**

PLL with reduced locking time

Boucle à verrouillage de phase avec temps de synchronisation réduit

(84) Benannte Vertragsstaaten:
**DE FR**

(72) Erfinder: **Tyulpanov, Alexander**
**Ru 445044 Togliatti (RU)**

(30) Priorität: **24.11.2005 DE 102005056033**

(74) Vertreter: **Müller, Wolf-Christian**
**Koch Müller Patentanwaltsgesellschaft mbH**
**Maaßstrasse 32/1**
**69123 Heidelberg (DE)**

(43) Veröffentlichungstag der Anmeldung:
**30.05.2007 Patentblatt 2007/22**

(73) Patentinhaber: **ATMEL Germany GmbH**
**74072 Heilbronn (DE)**

(56) Entgegenhaltungen:
**EP-A2- 0 565 127**      **US-A1- 5 497 126**
**US-A1- 5 874 863**      **US-B1- 6 563 386**

## Beschreibung

Die Erfindung betrifft eine Phasenregelkreis der im Oberbegriff des Patentanspruchs 1 genannten Art, also eine Phasenregelkreis, insbesondere in oder für eine Transceiverschaltung eines Reifendruckkontrollsystems, mit nacheinander angeordnetem Phasenvergleicher zur Erzeugung eines Phasendifferenzsignals aus einem Referenzeingangssignal und einem Ausgangssignal, Schleifenfilter zum Filtern des Phasendifferenzsignals und durch das gefilterte Phasendifferenzsignal gesteuertem Oszillator zur Erzeugung des Ausgangssignals. Die Erfindung betrifft ferner eine Transceiverschaltung eines Reifendruckkontrollsystems.

Phasenregelkreise (PLL; englisch Phase-Locked-Look) sind in der Elektronik weit verbreitet und werden zur Erzeugung und Synchronisierung von Taktsignalen verwendet, beispielsweise von Taktsignalen in mikroelektronischen Schaltungen. Solche Phasenregelkreise sind in einer Vielzahl unterschiedlicher Ausführungsformen und Varianten allgemein bekannt. Lediglich zum grundsätzlichen Aufbau eines Phasenregelkreises sowie dessen Funktionsweise sei beispielsweise auf Tietze, Schenk, Halbleiterschaltungselektronik, 11. erweiterte Auflage, Springer Verlag, 1999, insbesondere Fig. 24.20, verwiesen.

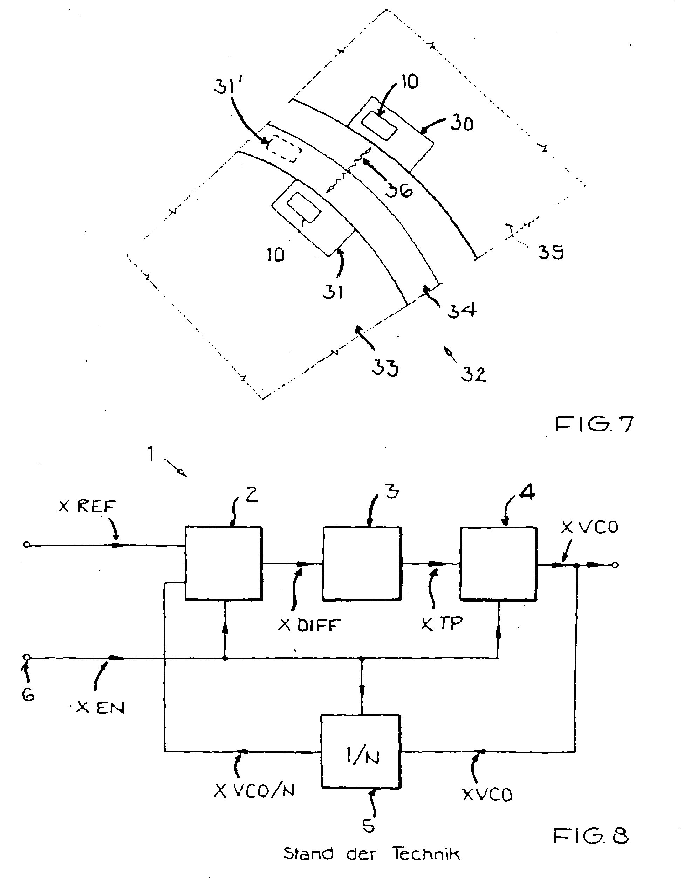

Fig. 8 zeigt einen solchen bekannten Phasenregelkreis. Ein Phasenregelkreis 1 enthält typischerweise einen Phasendetektor 2, ein Schleifenfilter 3 und einen Oszillator 4 in Reihenschaltung sowie einen Rückkopplungszweig mit darin angeordnetem Teiler 5. Der Phasenregelkreis 1 weist ferner einen Einschalteingang 6 auf, in den ein Enable-Signal XEN oder Rücksetzsignal zum Einschalten bzw. Rücksetzen des Phasenregelkreises 1 einkoppelbar ist. Bei einem Phasenregelkreis 1 handelt es sich um eine Regelschaltung, mittels der der Oszillator 4 auf die Phase eines Eingangssignals aufsynchronisiert wird. Wenn zwischen dem Eingangssignal XREF und dem Ausgangssignal XVCO des Phasenregelkreises 1 eine Phasen- und/oder Frequenzverschiebung auftritt, erzeugt der Phasendetektor 2 ein Detektorsignal XDIFF, mit welchem der nachgeschaltete Oszillator 4 so lange nachgeregelt wird, bis die Phase und/ oder Frequenz wieder synchronisiert sind. Im synchronisierten Zustand besteht Frequenzgleichheit und die Phasenverschiebung zwischen dem Eingangssignal und dem Oszillatorausgangssignal ist 0 bzw. 90°. Man spricht hier von einem eingerasteten Phasenregelkreis.

Bei einer Phasendifferenz zwischen Eingangssignal und Ausgangssignal erzeugt der Phasendetektor Spannungsimpulse, deren Länge der jeweiligen detektierten Phasendifferenz entsprechen. Diese Spannungsimpulse steuern die typischerweise im Phasendetektor angeordnete Ladungspumpe an, die in Abhängigkeit von den an dem Phasendetektor anliegenden Signalen bzw. dem Vorzeichen der Phasendifferenz einen impulsförmigen Proportionalstrom auf den Referenzstrom des stromgesteuerten Oszillators aufaddiert oder von diesem subtrahiert. Der Oszillator, dem der Referenzstrom zur Arbeitspunkteinstellung zugeführt wird, erzeugt daraus das frequenzmodulierte PLL-Ausgangssignal. Durch die Überlagerung des Referenzstroms des Oszillators mit dem impulsförmigen Proportionalstrom wird die Impulsdauerausgangsfrequenz des Oszillators verändert, welche dann als rückgekoppeltes Signal und damit als Regelgröße wieder in den Eingang des Phasendetektors rückgekoppelt wird.

Phasenregelkreise werden insbesondere in LF- und HF-Datenkommunikationssystemen zur Erzeugung nieder- bzw. hochfrequenter Signale verwendet. Wird der Phasenregelkreis eingeschaltet, benötigt der Phasenregelkreis auf Grund von Einschwingvorgängen eine gewisse Zeit, bis er eingerastet ist. Diese Zeit wird im Folgenden als Einschwingzeit (engl.: settle time) oder auch als Einrastdauer bezeichnet. Dasselbe gilt, sofern der Phasenregelkreis über ein Rücksetzsignal, z. B. einen Reset, zurückgesetzt wird. Die Einschwingzeit kann allerdings nicht zur Datenkommunikation genutzt werden, sodass der Bedarf besteht, diese so kurz wie möglich zu halten. Bei herkömmlichen PLL Schaltungen beträgt die Einschwingzeit im Falle eines LF-Signals von 125 kHz etwa 1 ms.

Aus der Druckschrift US 6 563 386 B1 ist eine PLL Schaltung bekannt, die das Hängenbleiben des Ausgangs der PLL Schaltung durch ein Initialisieren der PLL Schaltung beendet. Hierzu wird der Ausgangsspannung der PLL Schaltung überprüft.

Die Einschwingzeit hängt wesentlich von dem Phasenfehler $\Delta\varphi$ am Ausgang des Phasendetekors 2 ab. Für den Phasenfehler $\Delta\varphi$ ergibt sich der folgende Zusammenhang:

$$\Delta\varphi = \varphi_{REF} - \varphi_{VCO} \qquad (1)$$

mit

$$\varphi_{REF} = \int \omega_{REF} \, dt \qquad (2)$$

$$\varphi_{VCO} = \int \omega_{VCO}\, dt\ -\ \varphi_0 \qquad\qquad (3)$$

gilt

$$\Delta\varphi = \int \omega_{REF}\, dt\ -\ \int \omega_{VCO}\, dt\ -\ \varphi_0 \qquad\qquad (4)$$

Mit der Näherung

$$\varphi_{REF} \approx \varphi_{VCO} \qquad\qquad (5)$$

gilt

$$\Delta\varphi \approx \varphi_0 \qquad\qquad (6)$$

$\phi_{REF}$ bezeichnet die Phase des Referenzsignals XREF. $\phi_{VCO}$ bezeichnet die Phase des Ausgangssignals XVCO, also des Signals am Ausgang des Oszillators. $\omega_{REF}$ bzw. $\omega_{VCO}$ bezeichnen die entsprechenden komplexen Frequenzen dieser Signale. $\phi_0$ bezeichnet die so genannte Anfangsphase, also diejenige Phase, die das Referenzsignal XREF bei einem Einschalten oder Rücksetzen des Phasenregelkreises aufweist.

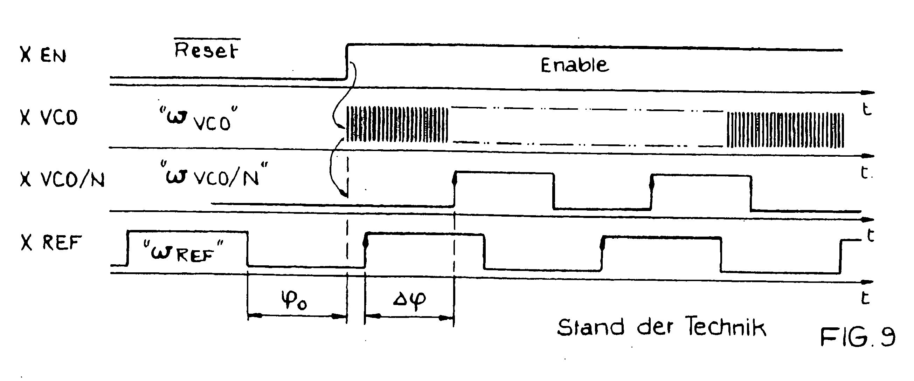

Der obige Zusammenhang bei einem Einschwingvorgang eines bekannten Phasenregelkreises sei anhand der Signal-Zeit-Diagramme in Fig. 9 dargestellt.

Nach einem Rücksetzen bzw. Einschalten des Phasenregelkreises 1 werden der Phasendetektor 2, der Oszillator 4 und der Teiler 5 zurückgesetzt und damit eingeschaltet und beginnen zu arbeiten. Da das Referenzsignal XREF hingegen unabhängig von dem Rücksetzen des Phasenregelkreises 1 ist, ist somit eine Anfangsphase $\phi_0$ bezogen auf einen Signalwechsel dieses Referenzsignals XREF und dem Einschalten der PLL-Schaltung 1 definiert. Gemäß der obigen Gleichungen entspricht diese Anfangsphase $\phi_0$ etwa dem Phasenfehler $\Delta\varphi$. Je nachdem zu welchem Zeitpunkt der Signalwechsel des Referenzsignals XREF bezogen auf das Einschalten bzw. Rücksetzen der PLL-Schaltung 1 erfolgt ist, ergibt sich eine mehr oder weniger große Anfangsphase $\phi_0$ und damit ein entsprechend großer Phasenfehler $\Delta\varphi$.

Phasenregelkreise werden insbesondere auch in Transceiver-Schaltungen von Reifendruckkontrollsysternen verwendet. Moderne Reifendruckkontrollsysteme weisen als Transceiver einen Transponder auf, der zum Beispiel an einer Felge eines Reifens angeordnet ist. Dieser Transponder kann mit einer karroserieseitigen Transceiver-Schaltung in datenkommunikative Verbindung gebracht werden. Um nun den Reifendruck oder auch andere reifenspezifische Parameter im Betrieb des Kraftfahrzeuges, das heißt während der Fahrt, zu ermitteln, steht auf Grund des sich mit dem Reifen drehenden Transponders somit eine vergleichsweise geringe Zeit zur Verfügung, innerhalb der die Datenkommunikation zwischen dem Transponder im Reifen und der Transceiver-Schaltung im Radkasten aufgebaut und die Datenkommunikation zum Austausch der reifenspezifischen Parameter durchgeführt werden kann. Im Falle sehr hoher Geschwindigkeiten (zum Beispiel 300 km/h) beträgt das Zeitfenster für diese Datenkommunikation nur etwa 2 msec. Innerhalb dieses Zeitfensters muss der Transponder mit Energie versorgt werden, der Phasenregelkreis auf die Nennfrequenz eingerastet sein und anschließend die eigentliche Datenkommunikation zur Übermittlung der reifenspezifischen Parameter durchgeführt werden. Ist nun, wie im oben beschriebenen Beispiel, die Einschwingzeit des Phasenregelkreises relativ groß, dann steht für die eigentliche Datenkommunikation eine vergleichsweise geringe Zeit zur Verfügung, die für viele Anwendungen für eine ordnungsgemäße Datenkommunikation nicht mehr ausreicht. Damit ist insbesondere bei solchen Situationen das Reifendruckkontrollsystem nicht mehr funktionsfähig. Dies ist ein Zustand, den es möglichst zu vermeiden gibt, insbesondere da bei den genannten Situationen (im Falle einer hohen Geschwindigkeit) der Bedarf der Messung und Überwachung reifendruckspezifischer Parameter am größten ist.

Vor diesem Hintergrund liegt der vorliegenden Erfindung daher die Aufgabe zugrunde, die Einschwingzeit eines Phasenregelkreises zu verringern.

Erfindungsgemäß wird diese Aufgabe durch einen Phasenregelkreis mit den Merkmalen des Patentanspruchs 1 und/oder durch eine Transceiver-Schaltung mit den Merkmalen des Patentanspruchs 20 gelöst.

Demgemäß ist vorgesehen:

- Ein Phasenregelkreis (PLL) mit reduzierter Einschwingzeit, insbesondere in oder für eine Transceiverschaltung eines Reifendruckkontrollsystems, mit in einem Signalpfad nacheinander angeordnetem Phasenvergleicher zur Erzeugung eines Phasendifferenzsignals durch Vergleichen eines Referenzeingangssignals mit einem Ausgangssignal, Schleifenfilter zum Filtern des Phasendifferenzsignals und durch das gefilterte Phasendifferenzsignal gesteuertem Oszillator zur Erzeugung des Ausgangssignals, wobei eine Einpassschaltung zur Verringerung der Einschwingzeit bei einem Einschalten des Phasenregelkreises vorgesehen ist, welche das tatsächliche Einschalten des Phasenregelkreises mit dem Signalverlauf des Referenzeingangssignals korreliert. (Patentanspruch 1)

- Eine Transceiverschaltung eines Reifendruckkontrollsystems, mit einer Vorrichtung zur Erzeugung und/oder Synchronisation eines Taktsignals, welche erfindungsgemäßen Phasenregelkreis aufweist, um im Betrieb eine lediglich kurzzeitige Datenkommunikation zu einer weiteren Transceiverschaltung desselben Reifendruckkontrollsystems aufzubauen. (Patentanspruch 20)

Die der vorliegenden Erfindung zugrunde liegende Erkenntnis besteht darin, dass der Phasenfehler und damit die Einschwingzeit maßgeblich davon abhängen, zu welchem Zeitpunkt der Phasenregelkreis relativ zu einem Referenzeingangssignal eingeschaltet bzw. rückgesetzt wird. Die Idee der vorliegenden Erfindung besteht nun darin, das Einschalten bzw. Rücksetzen des Phasenregelkreises mit dem Signalverlauf des Referenzsignals zu korrelieren.

Korrelieren bedeutet in diesem Zusammenhang, dass das tatsächliche Einschalten des Phasenregelkreises bei Vorhandensein eines Einschaltsignals zu einem jeweils vorbestimmten, fest vorgegebenen Zeitpunkt des Referenzeingangssignals vorgenommen wird. Dieser fest vorgegebene Zeitpunkt kann zum Beispiel aus dem Signalverlauf des Referenzsignals abgeleitet werden.

Unter dem tatsächlichem Einschalten ist zu verstehen, dass der Phasenregelkreis trotz Vorhandensein eines Einschaltsignals (beispielsweise eines Enable-Signals oder Rücksetzsignals), welches ein Einschalten bzw. Rücksetzen des Phasenregelkreises anzeigen soll, erst dann eingeschaltet wird, wenn gleichzeitig der fest vorgegebene Zeitpunkt des Referenzeingangssignals durchlaufen ist. Für das tatsächliche Einschalten des Phasenregelkreises reicht somit das reine Einschalt- bzw. Rücksetzsignal noch nicht aus. Vielmehr sind zwei Einschaltbedingungen erforderlich, das heißt einerseits das Vorhandensein des Einschalt-Signals bzw. Rücksetzsignals und andererseits das Vorhandensein des fest vorgegebenen Zeitpunktes im Signalverlauf des Referenzeingangssignals.

Als fest vorgegebener Zeitpunkt wird vorzugsweise ein vorher anzugebender, definierter Signalwechsel, beispielsweise die abfallende und/oder die ansteigende Flanke des Referenzeingangssignals, herangezogen. Dadurch wird gewährleistet, dass der Phasenregelkreis exakt zu dem Zeitpunkt eingeschaltet wird, bei dem das Referenzsignal ebenfalls einen Signalwechsel aufweist, sodass der Phasenregelkreis beim Einschwingen bereits eine minimale Phasendifferenz, idealerweise sogar keine Phasendifferenz, aufweist.

Da der Phasenregelkreis somit nur eine sehr geringe Phasendifferenz ausregeln muss, ist er bereits in kürzester Zeit eingerastet, was insgesamt zu einer minimalen Einschwingzeit führt. Insbesondere bei Anwendung in einem Reifendruckkontrollsystem ergibt sich dadurch der besondere Vorteil, dass dadurch eine größere Zeit für die eigentliche Datenkommunikation zur Verfügung steht, da der Phasenregelkreis eine minimale Zeit zum Einschwingen des Phasenregelkreises benötigt.

Vorteilhafte Ausgestaltungen und Weiterbildungen der Erfindung sind den Unteransprüchen sowie der Beschreibung unter Bezugnahme auf die Zeichnung entnehmbar.

In einer vorteilhaften Ausgestaltung stellt die Einpassschaltung ausgangsseitig ein erstes Steuersignal bereit, über welches bei einem Einschalten des Phasenregelkreises zumindest der Oszillator erst bei einem Signalwechsel des Referenzeingangssignals zugeschaltet wird. Dieses erste Steuersignal steuert somit das tatsächliche Einschalten des Phasenregelkreises und somit die Korrelation zwischen dem Vorliegen einer ersten Einschaltbedingung (Reset, Enable) und dem Vorhandensein einer zweiten Einschaltbedingung (vorbestimmter Zeitpunkt), also eines Signalwechsels des Referenzeingangssignals.

In einer typischen Ausgestaltung enthält die Einpassschaltung einen ersten Eingang zur Einkopplung des Referenzeingangssignals und einen zweiten Eingang zur Einkopplung eines Einschaltsignals. Als Einschaltsignal fungiert zum Beispiel das Enable-Signal oder ein Reset-Signal. Als Signalwechsel kommt hier beispielsweise eine abfallende Signalflanke oder eine ansteigende Signalflanke des Referenzeingangssignals in Frage, wobei vorzugsweise ein solcher Signalwechsel verwendet wird, der dem entsprechendem Signalwechsel des Einschaltsignals entspricht, das heißt im Falle einer ansteigenden Flanke des Einschaltsignals ist hier auch eine ansteigende Flanke des Referenzeingangssignals zu verwenden. Dieses Einschaltsignal versetzt den Phasenregelkreis in die Lage, über ein erstes Steuersignal eingeschaltet zu werden. Die Einpassschaltung verknüpft das Referenzeingangssignal nun mit dem Einschaltsignal und erzeugt daraus das erste Steuersignal, welches den Phasenregelkreis einschaltet, wobei dieses erste Steuersignal an einem Ausgang der Einpassschaltung abgreifbar ist.

In einer vorteilhaften Ausgestaltung weist die Einpassschaltung zumindest ein Latch auf, welches der Bereitstellung des ersten Steuersignals dient.

Vorzugsweise ist dieses Latch als Flip-Flop ausgebildet, welches somit die jeweiligen Zustände bzw. logischem Pegel des Referenzeingangssignals und des Einschaltsignals speichert. Vorzugsweise wird hier ein RS-Flip-Flop oder ein DQ-Flip-Flop verwendet. Denkbar wären allerdings auch andere Ausgestaltungen der Einpassschaltung, wenngleich die Verwendung eines Flip-Flops oder eines herkömmlichen Latches eine schaltungstechnisch sehr einfache und damit zu bevorzugende Realisierung der Einpassschaltung darstellt.

In einer typischen Ausgestaltung ist ein Rückkopplungspfad vorgesehen, über welchen ein aus dem Ausgangssignal durch Herunterteilen mit einem vorgegebenen oder einstellbaren Teilungsfaktor abgeleitetes Rückkopplungssignal in einen Eingang der Phasenvergleicherschaltung rückkoppelbar ist. In dem Rückkopplungspfad ist typischerweise ein (Frequenz-)Teiler oder auch ein Frequenzvervielfacher angeordnet.

Einer Minimalvariante der erfindungsgemäßen Einpassschaltung zufolge weist zumindest der Oszillator einen Steuereingang auf, über den das erste Steuersignal in den Oszillator einkoppelbar ist und über den somit beim Einschalten des Phasenregelkreises dieser erst bei einem Signalwechsel des Referenzeingangssignals zugeschaltet wird. Als Eingang kann zum Beispiel ein Enable-Eingang oder ein Rücksetzeingang vorgesehen sein. Über dieses Einschaltsignal wird der Oszillator eingeschaltet und erzeugt sofort, da heißt ohne Einschwingen, ein entsprechendes Oszillator-Ausgangssignal. Dieses Oszillator-Ausgangssignal bildet gleichsam das Ausgangssignal des Phasenregelkreises und wird über den Rückkopplungspfad dem Phasendetektor zugeführt. Ein Oszillator weist typischerweise keinerlei Einrastzeit und damit keinerlei Einschwingzeit auf. Man verliert hier allerdings maximal eine Periode, da das vom Oszillator bereitgestellte Ausgangssignal eben eine Taktperiode benötigt, um über den Rückkopplungspfad zum Eingang der Phasenvergleicherschaltung zu gelangen. Allerdings wird am Ausgang des Phasendetektors ein Differenzsignal erzeugt, welches bereits eine mehr oder weniger minimale Phasendifferenz widerspiegelt.

In einer vorteilhaften Weiterbildung weist neben dem Oszillator auch der Phasenvergleicher und/oder der Teiler einen Steuereingang zur Einkopplung des Steuersignals auf. Das Steuersignal lässt sich damit sowohl dem Oszillator als auch dem Phasenvergleicher und dem Teiler zuführen, so dass damit der eben beschriebene Zeitverlust von einem Takt vermieden wird und mit dem Einschalten bzw. Zuführen des Steuersignals am Ausgang des Phasenvergleichers bereits ein Phasendifferenzsignal mit minimaler Phasendifferenz realisiert wird.

In einer typischen Ausgestaltung ist der Oszillator als spannungsgesteuerter Oszillator (VCO = Voltage Controlled Oscillator) ausgebildet. Denkbar wäre hier allerdings auch die Verwendung eines-stromgesteuerten Oszillators (ICO), wenngleich ein spannungsgesteuerter Oszillator aus energetischen Gründen, insbesondere in einem Reifendruckkontrollsystem, zu bevorzugen ist.

In einer typischen Ausgestaltung ist das Schleifenfilter als Tiefpassfilter ausgebildet. Vorzugsweise weist das Schleifenfilter eine möglichst geringe Bandbreite im Bereich bis 125 kHz auf. Dies ist insbesondere im Hinblick auf die Reduzierung des Rauschens des Schleifenfilters von Vorteil, da eine geringe Bandbreite des Schleifenfilters auch mit einem geringen Rauschsignal am Ausgang des Schleifenfilters einhergeht. Typischerweise ist das Schleifenfilter als analoges Schleifenfilter realisiert, wenngleich auch eine digitale Realisierung des Schleifenfilters zwar schaltungstechnisch aufwändiger, jedoch prinzipiell denkbar wäre.

In einer vorteilhaften Ausgestaltung ist der Phasenvergleicher als Phasendetektor ausgebildet. Grundsätzlich auch denkbar, insbesondere bei Anwendungen in Reifendruckkontrollsystemen, ist die Ausgestaltung des Phasenvergleichers als Phasenfrequenzdetektor. Im Falle eines Phasendetektors weist dieser in der einfachsten Ausgestaltung in Reihe zueinander angeordnete steuerbare Stromquellen auf, die jeweils über Steuersignale unterschiedlicher Polarität angesteuert werden. Der Abgriff der beiden Stromquellen bildet gleichermaßen den Ausgang des Phasenfrequenzdetektors. Die beiden Stromquellen des Phasenfrequenzdetektors sind idealerweise gleich groß dimensioniert, was allerdings auf Grund von herstellungsbedingten Toleranzen nie ganz der Fall ist. Insbesondere aus diesen Gründen ist es von Vorteil, dass bei einem Einschalten des Phasenregelkreises auch dem Phasenfrequenzdetektor das Steuersignal zugeführt wird.

In einer bevorzugten Ausgestaltung ist zwischen dem Phasenvergleicher und dem Schleifenfilter zumindest eine Ladungspumpe angeordnet. Hierzu ist es vorteilhaft, wenn eine Ladungspumpensteuerschaltung vorgesehen ist, die nach Maßgabe eines zweiten Steuersignals ein drittes Steuersignal zur Ansteuerung zumindest einer Ladungspumpe erzeugt. Das zweite Steuersignal zeigt dabei an, ob der Phasenregelkreis geschlossen ist oder nicht.

In einer sehr vorteilhaften Ausgestaltung sind zumindest zwei Ladungspumpen vorgesehen, wobei die erste Ladungspumpe einen geringeren Ladungspumpenstrom als die zweite Ladungspumpe erzeugt. Vorzugsweise ist dabei maximal eine der beiden Ladungspumpen und insbesondere genau eine Ladungspumpe aktiviert. Dabei ist die erste Ladungspumpe über das dritte Steuersignal aktivierbar, sofern der Phasenregelkreis eingerastet ist. Zusätzlich oder alternativ ist die zweite Ladungspumpe über das dritte Steuersignal aktivierbar, sofern der Phasenregelkreis nicht eingerastet ist.

Vorzugsweise sind zumindest zwei Phasenvergleicher vorgesehen, wobei der erste Phasenvergleicher als Phasendetektor und der zweite Phasenvergleicher als Phasenfrequenzdetektor ausgebildet ist. In einer bevorzugten Weiterbildung ist die erste Ladungspumpe dem Phasendetektor und die zweite Ladungspumpe dem Phasenfrequenzdetektor ausgangsseitig nachgeschaltet.

In einer bevorzugten Ausgestaltung ist eine so genannte Closed-Loop-Erkennungsschaltung vorgesehen, die erkennt, ob der Phasenregelkreis geschlossen ist oder nicht.

In einer Ausgestaltung ist der Teiler als 1/4-Teiler ausgebildet und ist somit dazu ausgelegt, das Ausgangssignal des Phasenregelkreises und dabei insbesondere dessen Frequenz und/oder dessen Phase durch vier zu teilen.

In einer weiteren Ausgestaltung der Erfindung ist eine Einrasterkennungsschaltung vorgesehen, die dazu ausgelegt ist, zu erkennen, ob der Phasenregelkreis eingerastet ist oder nicht. Im Falle eines eingerasteten Phasenregelkreises erzeugt die Einrasterkennungsschaltung ein Einraststeuersignal. Im Falle eines nicht eingerasteten Phasenregelkreises erzeugt die Einrasterkennungsschaltung ein dazu invertiertes Einraststeuersignal.

In einer typischen Ausgestaltung der erfindungsgemäßen Transceiver-Schaltung ist diese Bestandteil eines Transponders bzw. ist als Transponder ausgebildet. Diese Transceiver-Schaltung ist zudem an einer Felge einer Rades eines Kraftfahrzeuges anbringbar.

In einer weiteren Ausgestaltung der Erfindung ist der Transponder in einem Material eines Reifens, beispielsweise in dessen Gummimaterial, einvulkanisiert.

Die Erfindung wird nachfolgend anhand der in den schematischen Figuren der Zeichnung angegebenen Ausführungsbeispiele näher erläutert. Es zeigen dabei:

Fig. 1    ein erstes, allgemeines Ausführungsbeispiel eines erfindungsgemäßen Phasenregelkreises;

Fig. 2    ein zweites, bevorzugtes Ausführungsbeispiel eines erfindungsgemäßen Phasenregelkreises;

Fig. 3    Signal-Zeit-Diagramme zur Veranschaulichung der Funktionalität des Phasenregelkreises aus Fig. 2 bei einem Einschwingvorgang;

Fig. 4    ein drittes, bevorzugtes Ausführungsbeispiel eines erfindungsgemäßen Phasenregelkreises;

Fig. 5    Signal-Zeit-Diagramme zur Veranschaulichung der Funktionalität des Phasenregelkreises aus Fig. 4 bei einem Einschwingvorgang;

Fig. 6    ein viertes, besonders bevorzugtes Ausführungsbeispiel eines erfindungsgemäßen Phasenregelkreises;

Fig. 7    ein Blockschaltbild zur Darstellung eines Reifendruckkontrollsystems mit einem einen erfindungsgemäßen Phasenregelkreis enthaltenen Transponder;

Fig. 8    einen beispielsweise aus dem eingangs genannten Fachbuch von Tietze, Schenk heraus bekannten Phasenregelkreis;

Fig. 9    Signal-Zeit-Diagramme zur Veranschaulichung der Funktionalität des bekannten Phasenregelkreises aus Fig. 8 bei einem Einschwingvorgang.

In den Figuren der Zeichnung sind gleiche bzw. funktionsgleiche Elemente und Signale - sofern nichts anderes angegeben ist - mit denselben Bezugszeichen versehen worden.

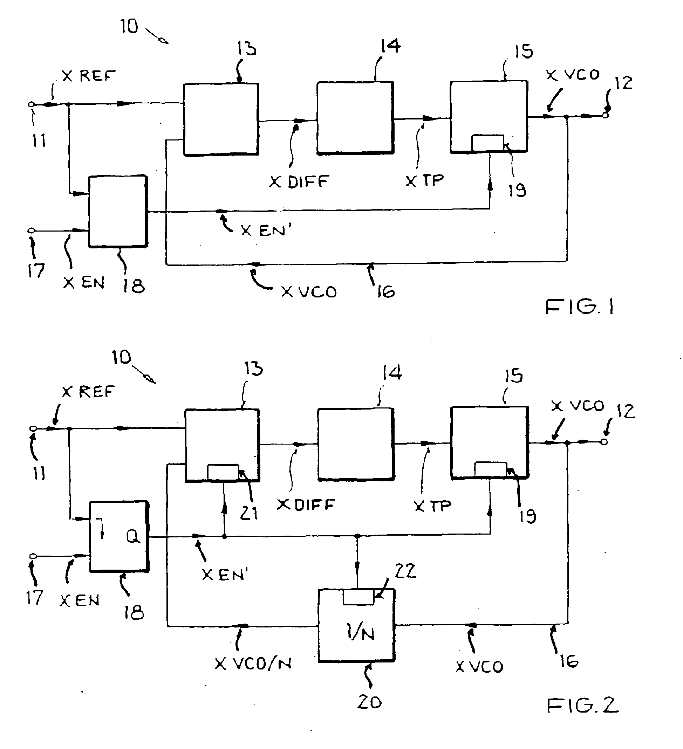

Fig. 1 zeigt ein Blockschaltbild eines allgemeinen Ausführungsbeispiels eines erfindungsgemäßen Phasenregelkreises. Der Phasenregelkreis 10 ist hier mit Bezugszeichen 10 bezeichnet. Der Phasenregelkreis weist einen Referenzeingang 11, in den ein Referenzeingangssignal XREF einkoppelbar ist, und einen Ausgang, aus dem ein Ausgangssignal XVCO abgreifbar ist, auf. Zwischen Eingang 11 und Ausgang 12 sind nacheinander ein Phasenvergleicher 13, ein Schleifenfilter 14 und ein Oszillator 15 in Reihe angeordnet. Ferner ist ein Rückkopplungspfad 16 vorgesehen, über den das Ausgangssignal XVCO abgreifbar und in einen Eingang des Phasenvergleichers 13 einkoppelbar ist.

Der erfindungsgemäße Phasenregelkreis 10 weist ferner einen weiteren Eingang 17 auf, über den ein zum Beispiel digitales Einschaltsignal XEN einkoppelbar ist. Ferner ist eine Steuereinrichtung 18 vorgesehen, die zwei Eingänge und einen Ausgang aufweist. Jeweils ein Eingang der Steuereinrichtung 18 ist mit einem der Eingänge 11, 17 verbunden. Am Ausgang der Steuereinrichtung 18 wird ein modifiziertes Einschaltsignal XEN' bereitgestellt, welches in Fig. 1 in einen Steuereingang 19 des Oszillators 15 eingekoppelt wird.

Fig. 2 zeigt ein zweites, gegenüber Fig. 1 erweitertes bevorzugtes Ausführungsbeispiel eines erfindungsgemäßen Phasenregelkreises. Der Phasenregelkreis 10 ist als digitaler Phasenregelkreis 10 ausgebildet.

Im Unterschied zu dem Ausführungsbeispiel in Fig. 1 ist hier der Phasenvergleicher 13 als Phasenfrequenzdetektor 13 ausgebildet. Das Schleifenfilter 14 (LF = Loop Filter) ist hier als schmalbandiges Tiefpassfilter ausgebildet. Der Oszillator 15 ist als spannungsgesteuerter Oszillator 15 ausgebildet.

Zusätzlich ist im Rückkopplungspfad 16 ein Frequenzteiler 20 vorgesehen. Der Frequenzteiler 20 ist dazu ausgelegt, die Frequenz des Ausgangssignals XVCO mit einem Teilungsfaktor 1/N zu multiplizieren, sodass am Frequenzteiler 20 ausgangsseitig das heruntergeteilte Ausgangssignal XVCO/N bereitsteht. Der Teiler 20 enthält insbesondere einen Zähler, beispielsweise einen Aufwärtszähler, der die von dem Oszillator 15 ausgangsseitig erzeugten Takte fortwährend zählt und der bei einer vorgegebenen Anzahl an Takten einen Signalwechsel des Taktsignals XVCO/N generiert.

Die erfindungsgemäße Steuereinrichtung 18 ist hier als Flip-Flop ausgebildet. Das Flip-Flop 18 ist in der Lage, bei einer abfallenden Flanke des Referenzeingangssignals XREF seinen Zustand zu ändern. Im Unterschied zu dem Ausführungsbeispiel in Fig. 1 weist hier auch der Phasenfrequenzdetektor 13 sowie der Teiler 20 einen Steuereingang 21, 22 auf. In sämtliche Steuereingänge 19, 21, 22 wird das Einschaltsignal XEN', welches von der Steuereinrichtung 18 bereitgestellt wird, eingekoppelt.

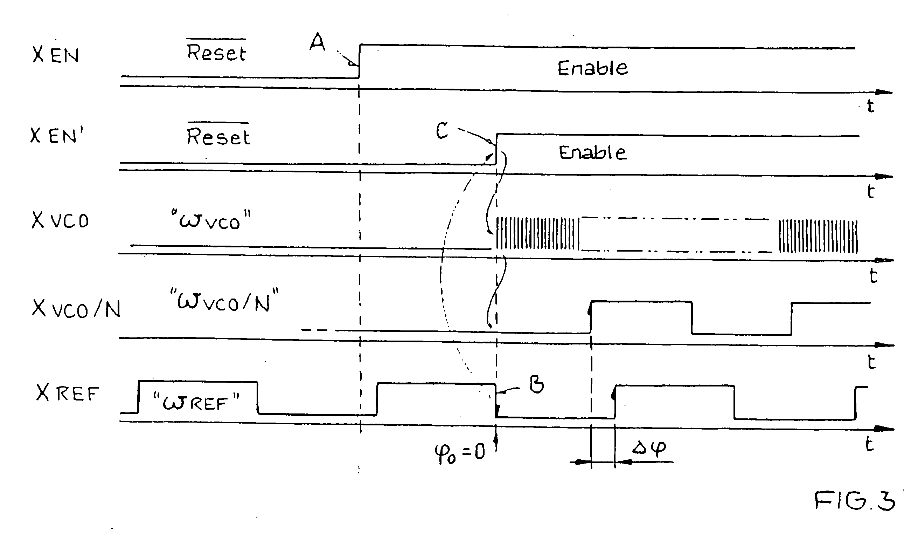

Nachfolgend sei die Funktionsweise des erfindungsgemäßen Phasenregelkreises entsprechend Fig. 2 insbesondere anhand der Signal-Zeit-Diagramme in Fig. 3 näher erläutert.

Im eingeschalteten und eingerasteten Zustand des Phasenregelkreises 10 erzeugt der Oszillator 15 fortwährend ein Oszillatorausgangssignal XVCO der Frequenz $\omega$VCO, welches am Ausgang 12 bereitsteht. Dieses Ausgangssignal XVCO wird über einen Teiler 20 als Taktsignal XVCO/N mit der Frequenz $\omega$VCO/N einem Eingang des Phasenfrequenzdetektors 13 zugeführt. Über den Referenzeingang 11 wird dem Phasenfrequenzdetektor 13 ferner ein Referenzeingangssignal XREF mit der Frequenz $\omega$REF zugeführt. Der Phasenfrequenzdetektor 13 vergleicht die beiden Signale XREF, XVCO/N miteinander und erzeugt ausgangsseitig ein Differenzsignal XDIFF. Das Differenzsignal XDIFF ist eine Funktion des Phasenfehlers der Phasen des Referenzeingangssignals XREF und des Taktsignals XVCO/N. Dieses Differenzsignal XDIFF wird über eine in Fig. 2 nicht dargestellte Treiberschaltung, die zum Beispiel Bestandteil des Phasenfrequenzdetektors 13 ist, einem nachgeschalteten Tiefpassfilter 14 zugeführt, der daraus ausgangsseitig ein tiefpassgefiltertes Referenzsignal XTP erzeugt. Dieses tiefpassgefilterte Signal XTP, welches nach wie vor eine Funktion der Phasendifferenz ist, dient der Ansteuerung des spannungsgesteuerten Oszillators 15, das heißt der Oszillator 15 wird der ermittelten Phasendifferenz entsprechend angesteuert, sodass die Frequenz des Oszillators 15 der Phasendifferenz entsprechend geändert wird.

Im ausgeschalteten oder zurückgesetzten Zustand des Phasenregelkreises 10 sind dessen Elemente, das heißt der Phasenfrequenzdetektor 13, das Schleifenfilter 14, der Oszillator 15 und der Teiler 20 inaktiv. In diesem Zustand wird der Steuereinrichtung 18 ein als Reset ("0") ausgebildetes Signal XEN zugeführt. Soll nun der Phasenregelkreis 10 eingeschaltet werden, dann wechselt dieses Signal XEN seinen logischen Pegel ("1"), was ein Einschalten (Enable) signalisieren soll (Signalwechsel A). Über den zweiten Eingang wird der Steuereinrichtung 18 das Referenzeingangssignals XREF zugeführt, welches im Beispiel in Fig. 3, also bei dem Signalwechsel A des Signals XEN, einen niedrigen logischen Pegel ("0") aufweist. Das Steuersignal XEN' bleibt daher zunächst auf einem niedrigen logischen Pegel ("0"), das heißt die Elemente des Phasenregelkreises 10 bleiben noch deaktiviert. Auch bei einen Signalwechsel des Referenzsignals von einem niedrigen ("0") auf einen hohen ("1") logischen Pegel bleibt das Steuersignal XEN' zunächst auf dem niedrigen logischen Pegel ("0"). Das Flip-Flop 18 ist nun derart ausgebildet, dass erst bei einem Signalwechsel B des Referenzeingangssignals XREF von einem hohen logischen Pegel ("1") zu einem niedrigen logischen Pegel ("0"), das heißt bei einer abfallenden Taktflanke, gleichzeitig ein Signalwechsel C des Steuersignals XEN' erfolgt. In der Fig. 2 ist dies mit einem nach unter gerichteten Pfeil am Dateneingang des Flip-Flops 18 angedeutet. Der Phasenfrequenzdetektor 13, der Oszillator 15 sowie der Teiler 20 werden nun über das Steuersignal XEN' bzw. dessen hohen logischen Pegel ("1") aktiviert, was insbesondere den Oszillator 15 sofort, das heißt ohne ein Einschwingen, dazu veranlasst, ausgangsseitig das Taktsignal XVCO bereitzustellen. Dadurch, dass der Oszillator 15 mehr oder weniger gleichzeitig zu den Zeitpunkten der Signalwechsel B, C zu takten beginnt, entsteht hier quasi keinerlei Eingangsphase $\phi0$. Es gilt also:

$$\varphi_O \approx 0 \qquad\qquad (7)$$

Mit den eingangs genannten Gleichungen (2) - (4) gilt also:

$$\Delta\varphi \approx \int \omega_{REF}\, dt \;-\; \int \omega_{VCO}\, dt \qquad\qquad (8)$$

und damit:

$$\Delta\varphi \approx \varphi_{REF} - \varphi_{VCO} \qquad\qquad (9)$$

Aus Gleichung (9) und Fig. 3 ist ersichtlich, dass der Phasenfehler $\Delta\varphi$ erfindungsgemäß minimal und im Falle $\varphi_{REF} = \varphi_{VCO}$ sogar idealerweise gleich Null ($\Delta\varphi=0$) ist. Dies bedeutet, dass der erfindungsgemäße Phasenregelkreis 10 bereits unmittelbar nach seinem Einschalten in den eingerasteten Zustand übergeht.

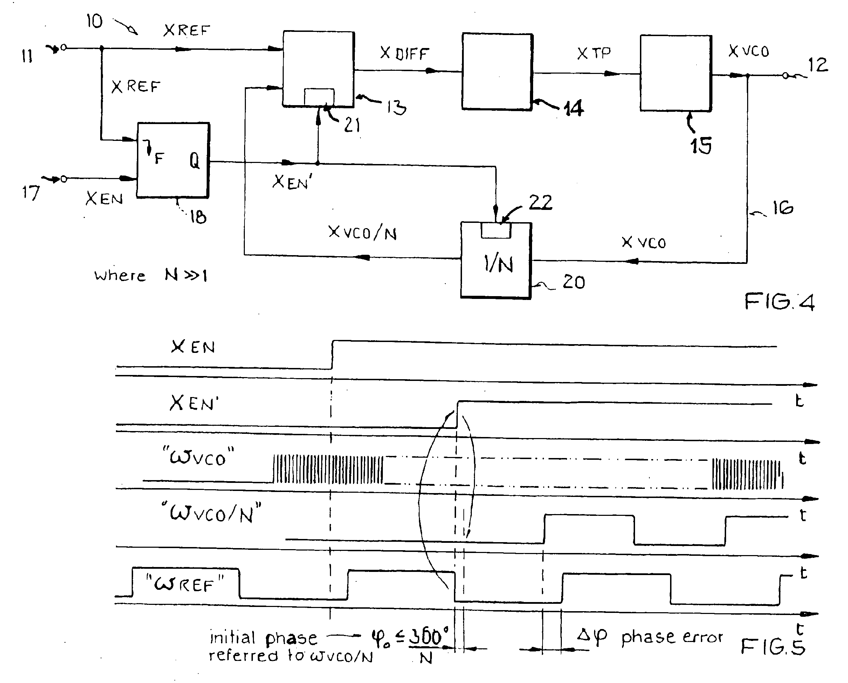

Fig. 4 zeigt ein drittes, ebenfalls bevorzugtes Ausführungsbeispiel eines erfindungsgemäßen Phasenregelkreises. Fig. 5 zeigt die entsprechenden Signal-Zeit-Diagramme zur Veranschaulichung der Funktionalität des Phasenregelkreises aus Fig. 4 bei einem Einschwingvorgang.

Im Unterschied zu dem Ausführungsbeispiel in der Fig. 2 ist bei dem Phasenregelkreis 10 in Fig. 4 keine Verbindungsleitung von dem Flip-Flop 18 zu dem Oszillator 15 vorgesehen, so dass der Oszillator 15 also nicht durch das Steuersignal XEN' angesteuert wird. Diese Variante ist insbesondere für solche Anwendungen von Vorteil, bei denen der Teilerkoeffizient N sehr viel größer als eins (N>>1) ist. Typische Wert für den Teilerkoeffizient N bewegen sich im Bereich zwischen 20 bis 100, vorzugsweise bei etwa N≈50.

Während sich die Phasenregelkreise 10 in den Fig. 1 und 2 im Wesentlichen auf statische Anwendungen beziehen, eignet sich der in der Fig. 4 dargestellt Phasenregelkreis zusätzlich auch für eine dynamische Anwendung der PLL-Schaltung 10. Vor allem bei Transpondern, die in einer sehr dynamischen Umgebung eingesetzt werden, bei der das Referenzsignals XREF also sehr schnellen Veränderungen unterzogen ist, ist diese Anwendung von besonderem Vorteil. Derartige Veränderungen ergeben sich zum Beispiel dadurch, dass das Referenzsignal XREF immer wieder verschwindet oder zumindest deutlich schwächer wird. Ist bedingt durch die sehr dynamische Umgebung die Qualität und damit die Signalamplitude des Referenzsignals XREF sehr schlecht oder sogar falsch, ist es häufig erforderlich, das Differenzsignal XDIFF am Ausgang des Phasenfrequenzdetektors 13 wegzuschalten und damit die Verbindung zwischen Phasenfrequenzdetektor 13 und Schleifenfilter 14 zu unterbrechen. Dadurch soll die Funktion des Phasenregelkreises 10 unterbrochen werden, um zu verhindern, dass der Oszillator 15 dem "schlechten" bzw. falschen Referenzsignal XREF folgt.

Trotz unterbrochenem Differenzsignal XDIFF kann es vorkommen, dass der Oszillator 15 (unbeabsichtigt) für eine gewisse Zeit weiterarbeitet. Dies liegt daran, dass der Oszillator 15 eingangsseitig mit dem Ausgang des Schleifenfilters 14 verbunden ist, dessen RC-Tiefpasselement in der Lage ist, aufgrund der geringen Leckströme im Schleifenfilter 14 Ladung über einen relativ langen Zeitraum zu speichern. Die sich daraus ergebende Spannung fungiert dann als Eingangsspannung für den nachgeschalteten spannungsgesteuerten Oszillators 15, der ohne weitere Vorkehrungen - wie dies in den Beispielen in den Fig. 1 und 2 der Fall ist - nun versucht, aus diesem gespeicherten Spannungssignal ein davon abgeleitetes Ausgangssignal zu erzeugen. Dies ist unerwünscht.

Die erfindungsgemäße Schaltung in Fig. 5 verhindert dies. Hierzu wird mittels einer speziellen Überwachungsanordnung die Qualität des Referenzsignals XREF überwacht. Ist die überwachte Qualität zu schlecht bzw. ist gar kein Referenzsignal XREF vorhanden, dann wird über das Steuersignal XEN' der Phasenvergleicher 13 deaktiviert und damit das Differenzsignal XDIFF unterbrochen. Sobald die Qualität des Referenzsignals XREF wieder ausreichend ist, kann der Phasenregelkreis 10 wieder geschlossen werden, beispielsweise durch Einschalten des Phasenvergleichers 13 mittels das Steuersignals XEN'. Allerdings erhält man aufgrund der Unterbrechung eine relativ geringe Eingangsphase $\varphi_0$. Die Eingangsphase $\varphi_0$ ist aber (deutlich) geringer als 360°/N, so dass der Phasenfehler $\Delta\varphi$ weitestgehend minimiert ist. Dies liegt daran, dass der Oszillator 15 zwar nicht synchronisiert werden kann, da dessen Frequenz möglichst gleichmäßig sein sollte. Jedoch können der Teiler 20 und der Phasenvergleicher 13 über das Steuersignal XEN' synchronisiert werden.

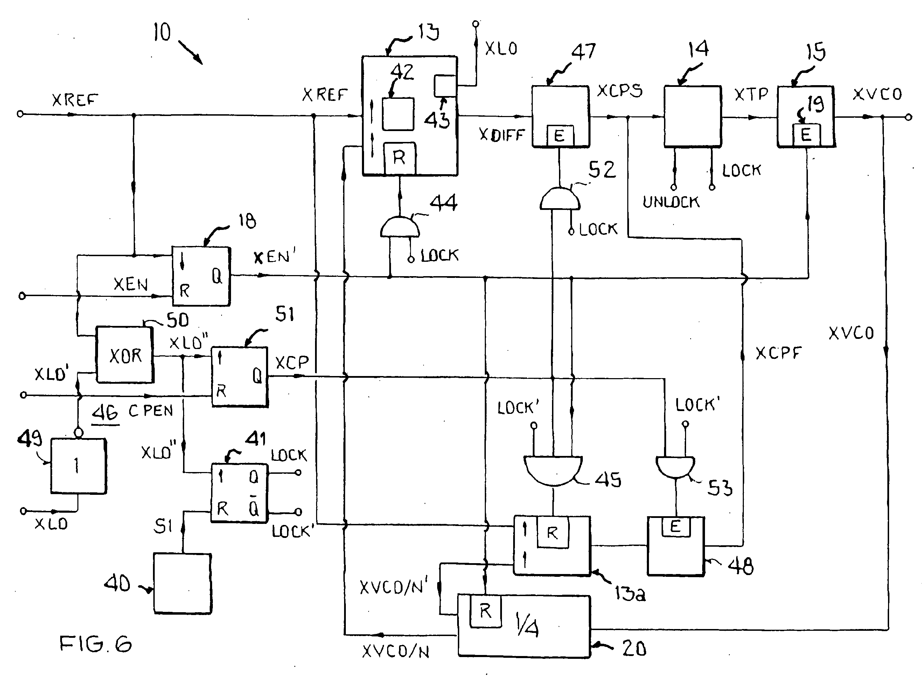

Fig. 6 zeigt ein viertes besonders bevorzugtes Ausführungsbeispiel des erfindungsgemäßen Phasenregelkreises. In dem Ausführungsbeispiel in der Fig. 6 sind die mit dem Buchstaben "a" versehenen Bezugszeichen jeweils den Elementen in dem Pfad, in welchem der Phasenfrequenzdetektor 13a angeordnet ist, zugeordnet. In Fig. 6 soll ein jeweils nach oben zeigender Pfeil an einem Eingang eines jeweiligen Schaltungselementes signalisieren, dass dieses Signal jeweils auf eine ansteigende Flanke des entsprechenden eingekoppelten Signals getriggert wird. In gleicher Weise bezeichnet ein nach unten gerichteter Pfeil, dass das jeweilige Schaltungselement mit der abfallenden Flanke des jeweils eingekoppelten Signals getriggert wird. Die mit E bezeichneten Eingänge eines jeweiligen Schaltungselementes bezeichnen so genannte Enable-Eingänge, über welche die Schaltungselemente eingeschalten werden. Die mit R bezeichneten Eingänge bezeichnen jeweils Reset-Eingänge, über welche die jeweiligen Schaltungselemente zurückgesetzt werden können.

In dem Ausführungsbeispiel in Fig. 6 ist sowohl ein als Phasendetektor 13 als auch ein Phasenfrequenzdetektor 13a ausgebildeter Phasenvergleicher vorgesehen. Diese beiden Phasenvergleicher 13, 13a arbeiten weitestgehend unabhängig voneinander, wobei der Phasendetektor vornehmlich im Falle eines eingerasteten Phasenregelkreises und der Phasenfrequenzdetektor im Falle eines noch nicht eingerasteten Phasenregelkreises 10 aktiv ist. Dies wird nachfolgend noch detailliert beschrieben.

Der Phasenregelkreis 10 enthält ferner einen mit Bezugzeichen 40 bezeichneten Einrastdetektor, der erkennt, ob die Frequenz des Referenzeingangssignals XREF eingerastet ist oder nicht. Ist die Frequenz noch nicht eingerastet, gibt der Frequenzdetektor 40 ein Steuersignal S1 aus, welches anzeigt, dass der Phasenregelkreis 10 noch nicht eingerastet ist. Dieses Steuersignal S1 wird dem Reset-Eingang R einer nachgeschalteten Einrasterkennungsschaltung 41 zugeführt, über welche diese zurückgesetzt wird. Diese Einrasterkennungsschaltung 41 erzeugt ausgangsseitig Statussignale LOCK, LOCK', wobei das Statussignal LOCK anzeigt, dass der Phasenregelkreis 10 eingerastet ist, wohingegen das Statussignal LOCK' anzeigt, dass der Phasenregelkreis 10 sich in einem nicht eingerasteten Zustand befindet. Die Einrasterkennungsschaltung 41 ist im vorliegenden Ausführungsbeispiel als DQ-Flip-Flop 41 ausgebildet. Das Flip-Flop 41 wird dabei mit der ansteigenden Flanke eines Statussignals XLO" getriggert, welches eine Information darüber enthält, ob der Phasenregelkreis 10 geschlossen ist. Das Statussignal LOCK ist am Datenausgang des Flip-Flops 41 und das Statutssignal LOCK' am invertierten Ausgang Q' des Flip-Flops 41 abgreifbar.

Der Phasendetektor 13 weist ferner eine Einrichtung 42 auf, die dazu ausgelegt ist, zu erkennen, ob der Phasenregelkreis 10 geschlossen ist. Diese Einrichtung 42 wird auch als so genannte Closed-Loop-Erkennungsschaltung bezeichnet. Ist der Phasenregelkreis 10 geschlossen, dann gibt die Einrichtung 42 ein Steuersignal XLO aus, welches einen geschlossenen Phasenregelkreis 10 anzeigt. Dieses Steuersignal XLO ist an einem Steuerausgang 43 des Phasendetektors 13 abgreifbar. Die Einrichtung 42 ermittelt diese Information aus der Phasenlage des Referenzeingangssignals XREF und des vom Teiler 20 heruntergeteilten Ausgangssignals XVCO/N. Vorzugsweise ist hierfür der Teiler 20 als 1/4 Teiler ausgebildet, der also das Ausgangssignal XVCO bzw. dessen Frequenz oder Phase durch vier teilt. Dieses durch vier geteilte Ausgangssignal XVCO wird mit der 0°-Phase sowie der 180 °-Phase des Referenzeingangssignals XREF verglichen. Aus diesem Vergleich kann die gewünschte Information, ob der Phasenregelkreis 10 geschlossen ist, gewonnen werden.

Dem Phasenfrequenzdetektor 13a wird - ähnlich wie dem Phasendetektor 13 - eingangsseitig das Referenzeingangssignal XREF sowie das heruntergeteilte Ausgangssignal XVCO/N' zugeführt, wobei diese jeweils im Phasenrefrenzdetektor 13a bei deren ansteigenden Signalflanken getriggert werden.

Der Phasendetektor 13 weist ferner einen Reset-Eingang 21 auf, über welchen der Phasendetektor 13 zurückgesetzt werden kann. Zur Gewinnung des entsprechenden Reset-Signals ist ein UND-Gatter 44 vorgesehen, dem jeweils das Statussignal LOCK und das Steuersignal XEN' zugeführt werden.

In gleicher Weise ist auch dem Phasenfrequenzdetektor 13a ein Reset-Signal in dessen Reset-Eingang 21 a zuführbar. Dieses Reset-Signal wird durch UND-Verknüpfung des Statussignals LOCK', des Steuersignals XEN' und eines Steuersignals XCP in einem UND-Gatter 45 erzeugt.

Das Steuersignal XCP signalisiert, ob bzw. welche der - nachfolgend noch ausführlich beschriebenen - Ladungspumpen 47, 48 angesteuert werden. Das Steuersignal XCP wird in einer eigens dafür vorgesehenen Ladungspumpensteuerschaltung 46 erzeugt. Die Ladungspumpensteuerschaltung enthält einen Inverter 49, ein dem Inverter 49 ausgangsseitig nachgeschaltetes XOR-Gatter 50 sowie ein diesem nachgeschaltetes DQ-Flip-Flop 51.

Der Inverter 49 invertiert das Steuersignal XLO des Phasendetektors 13, welches anzeigt, dass der Phasenregelkreis 10 geschlossen und somit nicht unterbrochen ist. Das so invertierte Steuersignal XLO' wird zusammen mit dem Referenzeingangssignal XREF in dem nachgeschalteten XOR-Gatter 50 entsprechend XOR-verknüpft, wodurch sich ein entsprechenden Statussignal XLO" ergibt. Das Statussignal XLO" wird jeweils den Dateneingängen des DQ-Flip-Flops 41 und des DQ-Flip-Flops 51 zugeführt. In den Reset-Eingang R des DQ-Flip-Flops 51 wird das Steuersignal CPEN eingekoppelt, über welches das DQ-Flip-Flop 51 also zurücksetzbar ist. Dieses Steuersignal CPEN gibt an, ob zumindest eine der beiden Ladungspumpen 47, 48 aktiviert werden soll. Das DQ-Flip-Flop 51 gibt ausgangsseitig das Steuersignal XCP zur Ansteuerung der Ladungspumpen 47, 48 sowie des Phasendetektors 13 und des Phasenfrequenzdetektors 13a aus.

Wie bereits oben beschrieben, weist der Phasenregelkreis 10 zwei Ladungspumpen 47, 48 auf. Jeweils eine dieser Ladungspumpen 47 ist dem Phasendetektor 13 ausgangsseitig nachgeschalten, wohingegen die andere Ladungspumpe 48 dem Phasenfrequenzdetektor 13a ausgangsseitig nachgeschaltet ist. Die Ladungspumpe 47 ist als "langsame" Ladungspumpe 47 ausgebildet und erzeugt daher ausgangsseitig einen relativ geringen Ladungspumpenstrom XCPS. Diese langsame Ladungspumpe 47 ist für den eingerasteten Zustand des Phasenregelkreises 10 vorgesehen.

Die dem Phasenfrequenzdetektor 13a ausgangsseitig nachgeschaltete Ladungspumpe 48 ist hingegen im Vergleich zur Ladungspumpe 47 signifikant schneller und ist daher dazu ausgelegt, ausgangsseitig einen vergleichsweise dazu hohen Ladungspumpenstrom XCPF bereitzustellen. Diese Ladungspumpe 48 dient dem Zweck, im nicht eingerasteten Zustand des Phasenregelkreises 10 einen vergleichsweise hohen Ladungspumpenstrom XCPF bereitzustellen, um den Phasenregelkreis 10 möglich schnell oder zumindest schneller, als dies mit der Ladungspumpe 47 möglich wäre, wieder einzurasten. Dieses Erfordernis ist im nicht eingerasteten Zustand nicht erforderlich, so dass die Ladungspumpe 47 einen vergleichsweise geringeren Strom XCPS im eingerasteten Zustand liefern kann.

Dabei ist maximal eine der beiden Ladungspumpen 47, 48 aktiviert. Hierzu ist jeder der Ladungspumpe 47, 48 ein UND-Gatter 53 zugeordnet, denen jeweils das Steuersignal XCP zugeführt wird. Dieses Steuersignal XCP wird im Falle des UND-Gatters 52 für die langsame Ladungspumpe 47 mit dem Statussignal LOCK UND-verknüpft, wohingegen das Steuersignal XCP im Falle des UND-Gatters 52 für die schnelle Ladungspumpe 48 mit dem dazu invertierten Steuersignal LOCK' UND-verknüpft wird. Somit liefert (maximal) lediglich eine dieser Ladungspumpen 47, 48 ausgangsseitig einen Ladungspumpenstrom CXPS, CXPF, der jeweils dem nachgeschalteten Schleifenfilter 14 zugeführt wird.

Das Schleifenfilter 14 erhält über entsprechende Steuereingänge ebenfalls die Statussignale LOCK, LOCK' und damit eine Information darüber, ob der Phasenregelkreis 10 nun eingerastet oder nicht eingerastet ist.

Das Steuersignal XCP wird ferner in einen Hold-Eingang des Phasendetektors 13 eingekoppelt. Dies bewirkt, dass bei Vorhandensein des Steuersignals XCP, also für den Fall, dass zumindest eine der Ladungspumpen 47, 48 eingeschaltet werden soll, der Phasendetektor 13 nicht zurückgesetzt wird, sondern dessen Funktion aufrecht erhalten wird. Dies ist für die Funktionsweise des erfindungsgemäßen Phasenregelkreises 10 und insbesondere für dessen schnelles Einrasten sehr wesentlich.

Das Ausführungsbeispiel in Fig. 6 zeichnet sich insbesondere dahingehend aus, dass ein außerordentlich schnelles Einrasten des Phasenregelkreises 10 gewährleistet ist, da zum Einen überwacht wird, ob der Phasenregelkreis 10 bereits eingerastet ist, und zum Anderen ob der Phasenregelkreis 10 geschlossen ist. Abhängig von diesen Informationen sowie durch Verknüpfung des Referenzeingangssignals XREF und das heruntergeteilten Ausgangssignals XVCO/N kann entweder die schnelle oder die langsame Ladungspumpe 47, 48 aktiviert werden, wodurch die Zeit, bis der Phasenregelkreis 10 wieder eingerastet ist, signifikant verkürzt wird.

Dies ermöglicht es, Phasenregelkreise 10 für sehr hohe Frequenzen, bspw. für Frequenzen von 100 MHz und darüber, insbesondere von 500 MHz und darüber, bereitzustellen. Dieses Verfahren eignet sich insbesondere auch für die Anwendung bei Transpondern, welche eine Datenkommunikation auf der Basis einer PSK-Modulation durchführen, wie dies z. B. bei Reifendruckkontrollsystemen der Fall ist.

Fig. 7 zeigt anhand eines Blockschaltbildes einen Ausschnitt eines Reifendruckkontrollsystems in einem Kraftfahrzeug, wobei dieses lediglich schematisch angedeutet wurde. Das Reifendruckkontrollsystem enthält eine karosserieseitige Transceiver-Schaltung 30 sowie einen radseitigen Transponder 31. Das lediglich ausschnittsweise dargestellte Rad 32 enthält eine Felge 33 sowie einen Reifen 34. Im vorliegenden Ausführungsbeispiel ist der Transponder 31 an einer Außenseite (Kante) der Radfelge 33 befestigt. Die karosserieseitige Transceiver-Schaltung 30 ist an einem Karosserieteil 35 im Bereich des Radkastens befestigt. Der Transponder 31 steht mit der Transceiver-Schaltung 30 in datenkommunikativer Verbindung, was mit dem Pfeil 36 angedeutet wurde. Der Transponder 31 weist einen erfindungsgemäßen Phasenregelkreis 10 auf. Zusätzlich oder alternativ kann auch die Transceiver-Schaltung 30 einen solchen erfindungsgemäßen Phasenregelkreis 10 enthalten.

Zusätzlich oder alternativ wäre es auch denkbar, wenn der Transponder 31' innerhalb des Reifens 34 angeordnet ist, beispielsweise indem der Transponder 31' in das (Gummi-)Materials des Reifens 34 einvulkanisiert ist. Vorzugsweise ist dabei der Transponder 31' möglichst weit von der Felge 33 entfernt angeordnet, was insbesondere hinsichtlich einer optimalen Datenkommunikation von Vorteil ist. Diese besonders vorteilhafte Variante der Anordnung des Transponders 31' ist in der Fig. 7 gestrichelt dargestellt.

So ist der erfindungsgemäße Phasenregelkreis nicht notwendigerweise für einen Transponder bzw. einen Transceiver-Schaltung in einem Reifendruckkontrollsystem ausgelegt, sondern kann bei beliebigen Anwendungen eingesetzt werden, die insbesondere eine möglichst geringe Einschwingzeit erfordern. Solche Anwendungen können beispielsweise in der Telekommunikation bei so genannten Frequenzsprungverfahren (frequency hopping) gegeben sein, bei denen für die Datenkommunikation unterschiedliche Frequenzen verwendet werden und zu diesem Zwecke sehr schnell von einer Frequenz auf andere gewechselt werden muss.

Der Phasenvergleicher kann auch als Phasendetektor, der Oszillator auch als stromgesteuerter Oszillator und das Schleifenfilter auch als Bandpassfilter oder Allpassfilter ausgebildet sein. Darüber hinaus stellt die Ausgestaltung der Steuereinrichtung als Flip-Flop eine schaltungstechnisch zwar sehr einfache, jedoch nicht zwingend erforderliche Ausführungsvariante dar. Vielmehr lässt sich diese auch durch jede beliebige Steuereinrichtung, die zum Beispiel Bestandteil einer programmgesteuerten Einrichtung, wie ein Mikroprozessor, oder einer fest verdrahteten Logikschaltung (z.B. FPGA, PLD) sein kann.

Bezugszeichenliste

1   Phasenregelkreis, PLL
2   Phasendetektor
3   Schleifenfilter

| | |
|---|---|
| 4 | Oszillator |
| 5 | Teiler |
| 6 | Einschalteingang |

| | |
|---|---|
| 10 | Phasenregelkreis, PLL-Schaltung, PLL |
| 11 | (Referenz-)Eingang |
| 12 | Ausgang |
| 13, 13a | Phasenvergleicher, Phasenfrequenzdetektor |
| 14 | Schleifenfilter, Tiefpass(-filter) |
| 15 | Oszillator, VCO, spannungsgesteuerter Oszillator |
| 16 | Rückkopplungspfad |
| 17 | (Einschalt-)Eingang |
| 18 | Steuereinrichtung, Flip-Flop |
| 19 | Steuereingang |
| 20 | (Frequenz-)Teiler |
| 21,21a | Steuereingang |
| 22 | Steuereingang |

| | |
|---|---|
| 30 | Transceiver-Schaltung |
| 31, 31' | Transponder |
| 32 | Rad |
| 33 | Radfelge |
| 34 | Reifen |
| 35 | Karosserieteil im Bereich des Reifenkastens |
| 36 | Datenkommunikationsverbindung |
| 40 | Einrastdetektor |
| 41 | Einrasterkennungsschaltung, DQ-Flip-Flop |
| 42 | Einrichtung zur Erkennung einer geschlossenen Schleife, Closed-Loop-Erkennungsschaltung |
| 43 | Steuerausgang |
| 44, 45 | UND-Gatter |
| 46 | Ladungspumpensteuerschaltung |
| 47,48 | Ladungspumpen |
| 49 | Inverter |
| 50 | XOR-Gatter |
| 51 | DQ-Flip-Flop |
| 52,53 | UND-Gatter |
| 54 | Hold-Eingang |

| | |
|---|---|
| XREF | Referenzeingangssignal |
| XDIFF | Differenzsignal |
| XTP | tiefpassgefiltertes Differenzsignal |
| XVCO | Ausgangssignal |
| XVCO/N, XVCO/N' | heruntergeteiltes Ausgangssignal, Taktsignal |
| XEN | Einschaltsignal |
| XEN' | Steuersignal |
| S1 | Steuersignal |
| XLO, XLO' | Steuersignal |
| LOCK, LOCK' | Statussignale |
| XCP | Steuersignal |
| XLO" | Statussignal |

| | |
|---|---|
| A | Signalwechsel |
| B | Signalwechsel |
| C | Signalwechsel |
| R | Reset-Eingang |
| E | Enable-Eingang |

**Patentansprüche**

1. Phasenregelkreis (10) mit in einem Signalpfad nacheinander angeordnetem

   - Phasenvergleicher (13) zur Erzeugung eines Phasendifferenzsignals (XDIFF) durch Vergleichen eines Referenzeingangssignals (XREF) mit einem Ausgangssignal (XVCO),
   - Schleifenfilter (14) zum Filtern des Phasendifferenzsignals (XDIFF) und
   - durch das gefilterte Phasendifferenzsignal (XTP) gesteuertem Oszillator (15) zur Erzeugung des Ausgangssignals (XVCO),

   **dadurch gekennzeichnet,**
   **dass** eine Einpassschaltung (18) zur Verringerung der Einschwingzeit bei einem Einschalten des Phasenregelkreises (10) vorgesehen ist, welche das tatsächliche Einschalten des Phasenregelkreises (10) mit dem Signalverlauf des Referenzeingangssignals (XREF) korreliert.

2. Phasenregelkreis nach Anspruch 1,
   **dadurch gekennzeichnet,**
   **dass** die Einpassschaltung (18) ausgangsseitig ein erstes Steuersignal (XEN') bereitstellt, über welches bei einem Einschalten des Phasenregelkreises (10) zumindest der Oszillator (15) erst bei einem Signalwechsel des Referenzeingangssignals (XREF) zugeschaltet wird.

3. Phasenregelkreis nach wenigstens einem der vorstehenden Ansprüche,
   **dadurch gekennzeichnet,**
   **dass** die Einpassschaltung (18) einen ersten Eingang zur Einkopplung des Referenzeingangssignals (XREF) und einen zweiten Eingang zur Einkopplung eines Einschaltsignals (XEN), welches den Phasenregelkreis in die Lage versetzt, über ein erstes Steuersignal (XEN') eingeschaltet zu werden, aufweist und dass die Einpassschaltung (18) das Referenzeingangssignal (XREF) und das Einschaltsignal (XEN) miteinander verknüpft und daraus das erste Steuersignal (XEN') erzeugt, welches den Phasenregelkreises (10) einschaltet.

4. Phasenregelkreis nach wenigstens einem der vorstehenden Ansprüche,
   **dadurch gekennzeichnet,**
   **dass** zur Bereitstellung des ersten Steuersignals (XEN') die Einpassschaltung (18) ein Latch (18), insbesondere ein Flip-Flop (18), aufweist.

5. Phasenregelkreis nach wenigstens einem der vorstehenden Ansprüche,
   **dadurch gekennzeichnet,**
   **dass** ein Rückkopplungspfad (16) mit einem darin angeordneten Teiler (20) vorgesehen ist, über welchen ein aus dem Ausgangssignal (XVCO) durch Herunterteilen mit einem Teilungsfaktor (1/N) abgeleitetes Rückkopplungssignal (XVCO/N) in einen Eingang des Phasenvergleichers (13) rückkoppelbar ist.

6. Phasenregelkreis nach wenigstens einem der vorstehenden Ansprüche,
   **dadurch gekennzeichnet,**
   **dass** der Oszillator (15) und/oder der Phasenvergleicher (13) und/oder der Teiler (20) zur Einkopplung des ersten Steuersignals (XEN') einen Steuereingang aufweist/aufweisen, über den der Oszillator (15) und/oder der Phasenvergleicher (13) und/oder der Teiler (20) bei einem Einschalten des Phasenregelkreises (10) erst bei einem Signalwechsel des Referenzeingangssignals (XREF) zugeschaltet wird/werden.

7. Phasenregelkreis nach wenigstens einem der vorstehenden Ansprüche,
   **dadurch gekennzeichnet,**
   **dass** der Oszillator (15) als spannungsgesteuerter Oszillator (15) ausgebildet ist.

8. Phasenregelkreis nach wenigstens einem der vorstehenden Ansprüche,
   **dadurch gekennzeichnet,**
   **dass** das Schleifenfilter (14) als Tiefpassfilter (14) ausgebildet ist.

9. Phasenregelkreis nach wenigstens einem der vorstehenden Ansprüche,
   **dadurch gekennzeichnet,**
   **dass** das Schleifenfilter (14) eine geringe Bandbreite im Bereich bis 125 KHz aufweist.

**10.** Phasenregelkreis nach wenigstens einem der vorstehenden Ansprüche,
**dadurch gekennzeichnet,**
**dass** der Phasenvergleicher (13) als Phasendetektor (13) und/oder als Phasenfrequenzdetektor (13a) ausgebildet ist.

**11.** Phasenregelkreis nach wenigstens einem der vorstehenden Ansprüche,
**dadurch gekennzeichnet,**
**dass** zwischen dem Phasenvergleicher (13) und dem Schleifenfilter (14) zumindest eine Ladungspumpe (47, 48) angeordnet ist.

**12.** Phasenregelkreis nach Anspruch 11,
**dadurch gekennzeichnet,**
**dass** eine Ladungspumpensteuerschaltung (46) vorgesehen ist, die nach Maßgabe eines zweiten Steuersignals (XLO), welches anzeigt, ob der Phasenregelkreis (10) geschlossen ist, ein drittes Steuersignal (XCP) zur Ansteuerung zumindest einer Ladungspumpe (47, 48) erzeugt.

**13.** Phasenregelkreis nach wenigstens einem der Ansprüche 11 oder 12,
**dadurch gekennzeichnet,**
**dass** zumindest zwei Ladungspumpen (47, 48) vorgesehen sind, wobei die erste Ladungspumpe (47) einen geringeren Ladungspumpenstrom (XCPS) als die zweite Ladungspumpe (48) erzeugt.

**14.** Phasenregelkreis nach Anspruch 13,
**dadurch gekennzeichnet,**
**dass** maximal eine der beiden Ladungspumpen (47, 48) aktiviert ist und dass die erste Ladungspumpe (47) über das dritte Steuersignal (XCP) aktivierbar ist, sofern der Phasenregelkreis (10) eingerastet ist, und/oder dass die zweite Ladungspumpe (48) über das dritte Steuersignal (XCP) aktivierbar ist, sofern der Phasenregelkreis (10) nicht eingerastet ist.

**15.** Phasenregelkreis nach wenigstens einem der vorstehenden Ansprüche,
**dadurch gekennzeichnet,**
**dass** zumindest zwei Phasenvergleicher (13, 13a) vorgesehen sind, wobei der erste Phasenvergleicher (13) als Phasendetektor (13) und der zweite Phasenvergleicher (13a) als Phasenfrequenzdetektor (13a) ausgebildet ist.

**16.** Phasenregelkreis nach wenigstens einem der Ansprüche 13-15,
**dadurch gekennzeichnet,**
**dass** die erste Ladungspumpe (47) dem Phasendetektor (13) und die zweite Ladungspumpe (48) dem Phasenfrequenzdetektor (13a) ausgangsseitig nachgeschaltet sind.

**17.** Phasenregelkreis nach wenigstens einem der vorstehenden Ansprüche,
**dadurch gekennzeichnet,**
**dass** eine Closed-Loop-Erkennungsschaltung (42) vorgesehen ist, die erkennt, ob der Phasenregelkreis (10) geschlossen ist.

**18.** Phasenregelkreis nach wenigstens einem der Ansprüche 5-17,
**dadurch gekennzeichnet,**
**dass** der Teiler die Frequenz und/oder die Phase des Ausgangssignals (XVCO) durch vier teilt.

**19.** Phasenregelkreis nach wenigstens einem der vorstehenden Ansprüche,
**dadurch gekennzeichnet,**
**dass** eine Einrasterkennungsschaltung (41) vorgesehen ist, die dazu ausgelegt ist, zu erkennen, ob der Phasenregelkreis (10) eingerastet ist, und die im Falle eines eingerasteten Phasenregelkreises (10) ein Einraststeuersignal (LOCK) erzeugt und im Falle eines nicht eingerasteten Phasenregelkreises (10) ein dazu invertiertes Einraststeuersignal (LOCK') erzeugt.

**20.** Transceiverschaltung (30, 31) eines Reifendruckkontrollsystems, mit einer Vorrichtung (10) zur Erzeugung und/ oder Synchronisation eines Taktsignals, welche einen Phasenregelkreis (10) nach wenigstens einem der vorstehenden Ansprüche aufweist, um im Betrieb eine lediglich kurzzeitige Datenkommunikation zu einer weiteren Transceiverschaltung (30, 31) desselben Reifendruckkontrollsystems aufzubauen.

**21.** Transceiverschaltung nach Anspruch 20,
**dadurch gekennzeichnet,**
**dass** die Transceiverschaltung (31) als Transponder (31) ausgebildet ist und an einer Felge (33) eines Rades (32) eines Kraftfahrzeuges anbringbar ist.

**22.** Transceiverschaltung nach Anspruch 21,
**dadurch gekennzeichnet,**
**dass** der Transponder (31') in ein Gummi-Material eines Reifens (34) des Rades (32) einvulkanisiert ist.

**Claims**

**1.** Phase-locked loop circuit (10) with successive arrangement in a signal path of

- a phase comparator (13) for producing a phase different signal (XDIFF) by comparison of a reference input signal (XREF) with an output signal (XVCO),
- a loop filter (14) for filtering the phase difference signal (XDIFF) and
- an oscillator (15), which is controlled by the filtered phase different signal (XTP), for generating the output signal (XVCO),

**characterised in that** a single-pass circuit (18) for reducing the rise time on switching-on of the phase-locked loop circuit (10) is provided, which correlates the actual switching-on of the phase-locked loop circuit (10) with the signal course of the reference input signal (XREF).

**2.** Phase-locked loop circuit according to claim 1, **characterised in that** the single-pass circuit (18) provides at the output a first control signal (XEN') by way of which on switching-on of the phase-locked loop circuit (10) at least the oscillator (15) is connected to only in the case of a signal change of the reference input signal (XREF).

**3.** Phase-locked loop circuit according to at least one of the preceding claims, **characterised in that** the single-pass circuit (18) has a first input for coupling in the reference input signal (XREF) and a second input for coupling in a switch-on signal (XEN), which sets the phase-locked loop circuit into the position of being switched on by way of a first control signal (XEN'), and that the single-pass circuit (18) links the reference input signal (XREF) and the switch-on signal (XEN) together and generates therefrom the first control signal (XEN') which switches on the phase-locked loop circuit (10).

**4.** Phase-locked loop circuit according to at least one of the preceding claims, **characterised in that** the single-pass circuit (18) comprises a latch (18), particularly a flip-flop (18), for providing the first control signal (XEN').

**5.** Phase-locked loop circuit according to at least one of the preceding claims, **characterised in that** a feedback path (16) with a divider (20) arranged therein is provided, by way of which a feedback signal (XVCO/N) derived from the output signal (XVCO) by subdividing with a division factor (1/N) can be fed back to an input of the phase comparator (13).

**6.** Phase-locked loop circuit according to at least one of the preceding claims, **characterised in that** the oscillator (15) and/or the phase comparator (13) and/or the divider (20) has or have for coupling-in of the first control signal (XEN') a control input by way of which the oscillator (15) and/or the phase comparator (13) and/or the divider (20) on switching-on of the phase-locked loop circuit (10) is or are connected only in the case of a signal change of the reference input signal (XREF).

**7.** Phase-locked loop circuit according to at least one of the preceding claims, **characterised in that** the oscillator (15) is constructed as a voltage-controlled oscillator (15).

**8.** Phase-locked loop circuit according to at least one of the preceding claims, **characterised in that** the loop filter (14) is constructed as a low-pass filter (14).

**9.** Phase-locked loop circuit according to at least one of the preceding claims, **characterised in that** the loop filter (14) has a small bandwidth in the range up to 125 kHz.

10. Phase-locked loop circuit according to at least one of the preceding claims, **characterised in that** the phase comparator (13) is constructed as a phase detector (13) and/or as a phase frequency detector (13a).

11. Phase-locked loop circuit according to at least one of the preceding claims, **characterised in that** at least one charge pump (47, 48) is arranged between the phase comparator (13) and the loop filter (14).

12. Phase-locked loop circuit according to claim 11, **characterised in that** a charge pump control circuit (46) is provided which, depending on a second control signal (XLO) indicative of whether the phase-locked loop circuit (10) is closed, generates a third control signal (XCP) for drive control of at least one charge pump (47, 48).

13. Phase-locked loop circuit according to at least one of claims 11 and 12, **characterised in that** at least two charge pumps (47, 48) are provided, wherein the first charge pump (47) generates a smaller charge pumping current (XCPS) than the second charge pump (48).

14. Phase-locked loop circuit according to claim 13, **characterised in that** at most one of the two charge pumps (47, 48) is activated and that the first charge pump (47) is activatable by way of the third control signal (XCP) insofar as the phase-locked loop circuit (10) is latched and/or that the second charge pump (48) is activatable by way of the third control signal (XCP) insofar as the phase-locked loop circuit (10) is not latched.

15. Phase-locked loop circuit according to at least one of the preceding claims, **characterised in that** at least two phase comparators (13, 13a) are provided, wherein the first phase comparator (13) is constructed as a phase detector (13) and the second phase comparator (23a) is constructed as a phase frequency detector (13a).

16. Phase-locked loop circuit according to at least one of claims 13 - 15, **characterised in that** the first charge pump (47) is connected downstream of the phase detector (13), and the second charge pump (48) downstream of the phase frequency detector (13a), at the output.

17. Phase-locked loop circuit according to at least one of the preceding claims, **characterised in that** a closed loop recognition circuit (42), which recognises whether the phase-locked loop circuit (10) is closed, is provided.

18. Phase-locked loop circuit according to at least one of claims 5 to 17, **characterised in that** the divider divides the frequency and/or the phase of the output signal (XVCO) by four.

19. Phase-locked loop circuit according to at least one of the preceding claims, **characterised in that** a latch recognition circuit (41 which is designed for the purpose of recognising whether the phase-locked loop circuit (10) is latched, is provided and in the case of a latched phase-locked loop circuit (10) generates a latch control signal (LOCK) and in a case of an unlatched phase-locked loop circuit (10) generates a latch control signal (LOCK') inverted relative thereto.

20. Transceiver circuit (30, 31) of a tyre pressure control system, comprising a device (10) for generation and/or synchronisation of a clock signal, which comprises a phase-locked loop circuit (10) according to at least one of the preceding claims in order in operation to establish a merely temporary data communication with a further transceiver circuit (30, 31) of the same tyre pressure control system.

21. Transceiver circuit according to claim 20, **characterised in that** the transceiver circuit (31) is constructed as a transponder (31) and can be mounted at a rim (33) of a wheel (32) of a motor vehicle.

22. Transceiver circuit according to claim 21, **characterised in that** the transponder (31') is vulcanised into a rubber material of a tyre (34) of the wheel (32).

**Revendications**

1. Boucle à verrouillage de phase (10) comprenant

    . un comparateur de phase (13) pour produire un signal de différence de phases (XDIFF) par comparaison d'un signal d'entrée de référence (XREF) à un signal de sortie (XVCO),
    . un filtre de boucle (14) pour filtrer le signal de différence de phases (XDIFF) et
    . un oscillateur (15) commandé par le signal de différence de phases filtré (XTP) pour générer le signal de sortie (XVCO),

disposés l'un après l'autre dans un chemin de signaux,
**caractérisée en ce que** l'on prévoit un circuit d'adaptation (18) pour réduire la période transitoire au moment de la connexion de la boucle à verrouillage de phase (10) qui corrèle la connexion réelle de la boucle à verrouillage de phase (10) à la courbe du signal d'entrée de référence (XREF).

2. Boucle à verrouillage de phase selon la revendication 1, **caractérisée en ce que** le circuit d'adaptation (18) met à disposition du côté sortie un premier signal de commande (XEN') au moyen duquel, lors de la connexion de la boucle à verrouillage de phase (10), au moins l'oscillateur (15) n'est connecté qu'au moment d'un changement du signal d'entrée de référence (XREF).

3. Boucle à verrouillage de phase selon au moins l'une des revendications précédentes, **caractérisée en ce que** le circuit d'adaptation (18) présente une première entrée pour le couplage du signal d'entrée de référence (XREF) et une deuxième entrée pour le couplage d'un signal de connexion (XEN) qui permet à la boucle de verrouillage de phase d'être connectée par l'intermédiaire d'un premier signal de commande (XEN'), et **en ce que** le circuit d'adaptation (18) combine le signal d'entrée de référence (XREF) et le signal de connexion (XEN) et produit à partir de cette combinaison le premier signal de commande (XEN') qui connecte la boucle à verrouillage de phase (10).

4. Boucle à verrouillage de phase selon au moins l'une des revendications précédentes, **caractérisée en ce que** pour mettre à disposition le premier signal de commande (XEN'), le circuit d'adaptation (18) présente un circuit de verrouillage (18), plus particulièrement une bascule flip flop (18).

5. Boucle à verrouillage de phase selon au moins l'une des revendications précédentes, **caractérisée en ce que** l'on prévoit une boucle de réaction (16) dans laquelle est monté un diviseur (20) par l'intermédiaire duquel on peut effectuer la réaction d'un signal de réaction (XVCO/N) déduit du signal de sortie (XVCO) par division selon un facteur de division (1/N) dans une entrée du comparateur de phases (13).

6. Boucle à verrouillage de phase selon au moins l'une des revendications précédentes, **caractérisée en ce que** l'oscillateur (15) et/ou le comparateur de phases (13) et/ou le diviseur (20) présente/présentent une entrée de commande pour la connexion du premier signal de commande (XEN'), par l'intermédiaire de laquelle l'oscillateur (15) et/ou le comparateur de phases (13) et/ou le diviseur (20) n'est/ne sont connectés lors d'une connexion de la boucle à verrouillage de phase (10) que lors d'un changement de signal du signal d'entrée de référence (XREF).

7. Boucle à verrouillage de phase selon au moins l'une des revendications précédentes, **caractérisée en ce que** l'oscillateur (15) est réalisé sous la forme d'un oscillateur (15) commandé en tension.

8. Boucle à verrouillage de phase selon au moins l'une des revendications précédentes, **caractérisée en ce que** le filtre de boucle (14) est réalisé sous la forme d'un filtre passe-bas (14).

9. Boucle à verrouillage de phase selon au moins l'une des revendications précédentes, **caractérisée en ce que** le filtre de boucle (14) présente une largeur de bande réduite dans la zone allant jusqu'à 125 KHz.

10. Boucle à verrouillage de phase selon au moins l'une des revendications précédentes, **caractérisée en ce que** le comparateur de phase (13) est réalisé sous la forme d'un détecteur de phase (13) et/ou d'un détecteur de fréquence de phase (13a).

11. Boucle à verrouillage de phase selon au moins l'une des revendications précédentes, **caractérisée en ce qu'**au moins une pompe de charge (47, 48) est disposée entre le comparateur de phase (13) et le filtre de boucle (14).

12. Boucle à verrouillage de phase selon la revendication 11, **caractérisée en ce que** l'on prévoit un circuit de commande de pompe de charge (46) qui en fonction d'un deuxième signal de commande (XLO), qui indique si la boucle à verrouillage de phase (10) est fermée, génère un troisième signal de commande (XCP) pour la commande d'au moins une pompe de charge (47, 48).

13. Boucle à verrouillage de phase selon au moins l'une des revendications 11 ou 12, **caractérisée en ce que** l'on prévoit au moins deux pompes de charge (47, 48), parmi lesquelles la première pompe de charge (47) produit un courant de pompe de charge (XCPS) plus faible que celui produit par la deuxième pompe de charge (48).

**14.** Boucle à verrouillage de phase selon la revendication 13, **caractérisée en ce qu'**au plus une des deux pompes de charge (47, 48) est activée et **en ce que** la première pompe de charge (47) peut être activée à l'aide du troisième signal de commande (XCP), dans la mesure où la boucle à verrouillage de phase (10) est connectée, et/ou **en ce que** la deuxième pompe de charge (48) peut être activée à l'aide du troisième signal de commande (XCP) dans la mesure où la boucle à verrouillage de phase (10) n'est pas connectée.

**15.** Boucle à verrouillage de phase selon au moins l'une des revendications précédentes, en ce que l'on prévoit au moins deux comparateurs de phase (13, 13a), dont le premier comparateur de phase (13) est réalisé sous la forme d'un détecteur de phase (13) et le deuxième comparateur de phase (13a) sous la forme d'un détecteur de fréquence de phase (13a).

**16.** Boucle à verrouillage de phase selon au moins l'une des revendications 13-15, **caractérisée en ce que** la première pompe de charge (47) est placée du côté sortie après le détecteur de phase (13) et **en ce que** la deuxième pompe de charge (48) est placée du côté sortie après le détecteur de fréquence de phase (13a).

**17.** Boucle à verrouillage de phase selon au moins l'une des revendications précédentes, **caractérisée en ce que** l'on prévoit un circuit de reconnaissance de boucle fermée (42) qui reconnaît si la boucle à verrouillage de phase (10) est fermée.

**18.** Boucle à verrouillage de phase selon l'une quelconque des revendications 5-17, **caractérisée en ce que** le diviseur divise la fréquence et/ou la phase du signal de sortie (XVCO) par quatre.

**19.** Boucle à verrouillage de phase selon au moins l'une des revendications précédentes, **caractérisée en ce que** l'on prévoit un circuit de reconnaissance de connexion (41), conçu pour reconnaître si la boucle à verrouillage de phase (10) est connectée et si celle-ci génère un signal de commande de connexion (LOCK) lorsque la boucle à verrouillage de phase (10) est connectée et si elle génère un signal de commande de connexion (LOCK') inverse de celui-ci lorsque la boucle à verrouillage de phase (10) n'est pas connectée.

**20.** Circuit trancepteur (30, 31) d'un système de contrôle de la pression de pneus, comprenant un dispositif (10) de génération et/ou de synchronisation d'un signal d'horloge, qui présente une boucle à verrouillage de phase (10) selon au moins l'une des revendications précédentes, pour établir en fonctionnement une communication de données uniquement limitée dans le temps vers un autre circuit trancepteur (30, 31) du même système de contrôle de la pression de pneus.

**21.** Circuit trancepteur selon la revendication 20, **caractérisé en ce que** le circuit trancepteur (31) est réalisé sous la forme d'un transpondeur (31) et peut être monté sur la jante (33) d'une roue (32) d'un véhicule automobile.

**22.** Circuit trancepteur selon la revendication 21, **caractérisé en ce que** le transpondeur (31') est intégré par vulcanisation dans le matériau en caoutchouc du pneumatique (34) d'une roue (32).

FIG.1

FIG.2

FIG.3

FIG.4

FIG.5

FIG. 6

EP 1 791 263 B1

FIG. 7

X REF

X EN

X DIFF

X TP

X VCO

X VCO/N

X VCO

1/N

Stand der Technik

FIG. 8

22

Stand der Technik

FIG. 9

EP 1 791 263 B1

**EP 1 791 263 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6563386 B1

**In der Beschreibung aufgeführte Nicht-Patentliteratur**

- **TIETZE ; SCHENK.** Halbleiterschaltungselektronik. Springer Verlag, 1999